# EUROPÄISCHE PATENTANMELDUNG

(11) **EP 2 178 114 A2**
(43) Veröffentlichungstag der Anmeldung: **21.04.2010**
(21) Anmeldenummer: 09172556.4
(22) Anmeldetag: 08.10.2009
(51) Int. Cl.: H01L 21/673, H01L 31/02

(54) **Verpackungen für dünnflächige, scheibenförmige Produkte**

(30) Priorität: 14.10.2008 DE 202008013468 U
(71) Anmelder: Christian Senning Verpackungsmaschinen GmbH & Co., D-28239 Bremen (DE)
(72) Erfinder: Laschütza, Dr. Helmut, 27721, Ritterhude (DE); Kuhnke, Jan, 27721, Ritterhude (DE); Köster, Maik, 27711, Osterholz-Scharmbeck (DE)
(74) Vertreter: Eisenführ, Speiser & Partner

(57) **Zusammenfassung**

Die Erfindung betrifft eine Verpackung für scheibenförmige, insbesondere dünne, spröde Produkte. Erfindungsgemäß handelt es sich bei der Verpackung um eine Folieneinschlagverpackung.

## Beschreibung

Die vorliegende Erfindung betrifft Verpackungen für scheibenförmige, insbesondere dünne und/oder spröde Produkte, insbesondere dünne Siliziumscheiben wie Wafer, Solarzellen oder dergleichen.

Solche scheibenförmigen Produkte kommen in der Halbleiter- oder Fotovoltaik-Industrie oder Mikromechanik zum Einsatz. Sie können beispielsweise aus Siliziumcarbit oder Galium-Arsenid bestehen, eine kreisrunde oder quadratische Form und eine Dicke von ca. 1 mm oder deutlich weniger aufweisen. Aus Wafern können z. B. Solarmodule oder integrierte Schaltkreise (Chips) hergestellt werden. Zum Transportieren der Produkte zwischen oft weit entfernt liegenden Verarbeitungsorten müssen diese verpackt werden.

Die DE 20 2006 005 284 U1 zeigt einen formstabilen Solarzellenbehälter mit einem Boden und daran angeformten Seitenwänden. Ein Einsatz, in den eine große Anzahl von Solarzellen oder Wafern aufeinander gestapelt eingelegt werden, kann in den Solarzellenbehälter eingelegt werden. Die Einsätze können je nach Größe oder Form der Solarzelle ausgetauscht werden. Der Behälter ist aus Polypropylen, Styropor oder anderen Kunststoffen gefertigt.

Die Herstellung dieser bekannten Behälter nebst Einsätzen ist relativ aufwändig, da kompliziert gestaltete Formen benötigt werden. Ferner sind die Behälter und Einsätze voluminös und weisen eine recht große Bauhöhe auf. Die Entnahme der einzelnen Solarzellen aus der Verpackung ist schwierig. Die häufig eine sehr glatte, geschliffene Oberfläche aufweisenden Wafer haften aneinander und lassen sich nur schwer voneinander trennen. Ferner werden die Wafer insbesondere beim Entnehmen leicht beschädigt. Aufgrund der Sprödigkeit des Materials kommt es leicht zu Sprödbrüchen. Angesichts der tendenziell immer dünner werdenden Produkte wird die Bruchgefahr weiter ansteigen.

Die DE 11 2006 000 773 offenbart ein Verpackungsverfahren und eine Verpackung, bei denen eine Vielzahl von Solarwafern parallel zueinander in vorgegebenen Abständen in starren sogenannten Pufferkörpern eingesetzt wird. Die direkt aufeinander geschichteten Solarwafer werden in einem ersten Verpackungsschritt mittels schrumpfbarer Folie bedeckt und die dadurch entstehende Einheit wird anschließend in ein Behältnis eingesetzt.

Auch diese Methoden sind aufwändig, eine Trennung der aufeinander geschichteten Wafer ist schwierig aus den oben beschriebenen Gründen, die Bruchgefahr und auch das Volumen der Verpackung sind groß.

Aufgabe der vorliegenden Erfindung ist es, Verpackungen für scheibenförmige Produkte, insbesondere dünne spröde Produkte wie Wafer oder Solarzellen anzugeben, mit denen die Produkte auf einfache, kostengünstige und sichere Weise verpackt werden können. Ferner sollen die Verpackungen so gestaltet sein, dass die Produkte möglichst schnell und beschädigungsfrei entnommen werden können. Die Verpackungen sollen ferner umweltfreundlich sein.

Die Erfindung löst die Aufgabe gemäß eines ersten Aspektes mit einer eingangs genannten Packung, bei der es sich um eine Folieneinschlagverpackung handelt.

Eine solche Folieneinschlagverpackung für scheibenförmige, flächige und insbesondere dünne und spröde Produkte wie Wafer oder Solarzellen, lässt sich auf einfache, kostengünstige und umweltverträgliche Weise einsetzen, um die regelmäßig empfindlichen Produkte einzuschlagen und damit zu verpacken. Der erforderliche Energiebedarf ist vergleichsweise gering und Wärmequellen wie bei schrumpfbaren Folien sind nicht erforderlich. Handelt es sich bei den Produkten gemäß einer bevorzugten Ausführungsform um Wafer oder Solarzellen, können diese erfindungsgemäß aufeinander gestapelt sein, und der gesamte Waferstapel ist direkt in die Folie eingeschlagen.

Eine bevorzugte Ausführungsform der Verpackung zeichnet sich dadurch aus, dass oben und unten an dem Stapel eine gepolsterte und/oder harte Deckplatte angebracht und der damit entstehende Stapel in Folie eingeschlagen wird. Durch gepolsterte oder harte Deckplatten ergibt sich ein zusätzlicher Schutz der empfindlichen Produkte und die Folieneinschlagverpackung hält die Produkte nebst Deckplatte, die unten und/oder oben angebracht sein kann, sicher zusammen.

Besonders bevorzugt ist eine Weiterbildung, bei der zwischen die Wafer oder Solarzellen des Stapels ein oder mehrere Trennelemente gelegt sind und der Waferstapel mit Trennelement(en) direkt in Folie eingeschlagen ist. Durch ein oder mehrere Trennelemente haften die Wafer nicht direkt aneinander und lassen sich bei der Entnahme schonend und zerstörungsfrei voneinander trennen.

Gemäß einer Weiterbildung handelt es sich um eine Kombination von Schrumpffolie und Folieneinschlagverpackung, so dass sich zusätzlich durch die Schrumpffolie weiterer Schutz ergibt, auch vor einem ungewollten Öffnen der Verpackung.

Zweckmäßigerweise weist die Folienverpackung eine definierte Möglichkeit zum Öffnen der Folie mittels eines Aufreißstreifens oder einer Perforation in der Folie auf. Die Entnahme lässt sich so weiter verbessern. Durch Ziehen an dem Aufreißstreifen lässt sich die Folie gezielt aufreißen.

Die Erfindung löst die Aufgabe gemäß eines weiteren Aspektes bei einer Verpackung der eingangs genannten Art dadurch, dass mindestens ein Trennelement zwischen benachbarten Wafern angeordnet ist.

Wie bereits zuvor erwähnt, lässt sich durch mindestens ein Trennelement zwischen benachbarten Wafern, insbesondere aber zwischen allen benachbarten Wafern eines Stapels sicherstellen, dass die Wafer schnell und ohne Beschädigung voneinander getrennt werden können. Zweckmäßigerweise ist das Trennelement als dünne Zwischenlage aus einem verformbaren Material, insbesondere Pappe, Papier, Tissuepapier, Folie, Filz, Flies, Kunststoff, Schaum, biologisch abbaubaren Schaum oder geschichtetem Material ausgebildet. Ferner ist es bevorzugt, dass das Trennelement im Wesentlichen dieselbe Form wie ein gestapelter Wafer aufweist, so dass gestapelte benachbarte Wafer nicht in Kontakt stehen und/oder dass das Trennelement eine solche Größe und/oder Form hat, dass benachbarte Wafer nur teilweise nicht in direktem Kontakt zueinander stehen.

Die Trennbarkeit lässt sich weiter dadurch verbessern, dass das Trennelement eine solche Größe aufweist und/oder so zwischen benachbarten Wafern angeordnet ist, dass es teilweise seitlich von benachbarten Wafern absteht, so dass der überstehende Teil manuell ergriffen werden kann.

Gemäß einer alternativen Ausführungsform sind mehrere Trennelemente im Wesentlichen identisch oder unterschiedlich ausgebildet, insbesondere so dass die Trennelemente aus verschiedenen Materialien geschichtet sind, um über die Schichtung einen Druck gegen die Verpackungsfolie im Gesamtpaket aufzubauen. Dadurch ergibt sich eine sehr stabile Verpackung.

Bei einer weiteren alternativen Ausführungsformen ist vorgesehen, dass einzelne Trennelemente von ihrer Oberflächenstruktur so gestaltet sind, dass das Produkt sich sehr einfach von dem Trennelement lösen lässt, insbesondere dadurch, dass Luftströmung zwischen dem Trennelement und dem Produkt einfach möglich wird, wie zum Beispiel durch Noppen, strukturierte Luftkanäle, Ausschnitte oder Durchgänge im/ auf dem Trennelement. Da die gestapelten Produkte "so nicht an einander" haften können sie abgehoben werden.

Die Erfindung löst die Aufgabe gemäß einem weiteren Aspekt ferner mit einer Verpackung mit den Merkmalen des Anspruchs 17, wonach mindestens ein Polsterelement an einer Außenseite der gestapelten Wafer angeordnet ist. Ein derartiges Polsterelement schützt die Wafer vor äußeren Kräften während eines Transports, etwa vor Stößen. Die Außenseite bedeutet hier die Umfangsfläche eines Stapels aus Wafern.

Gemäß einer Weiterbildung wird vorgeschlagen, dass zusätzlich jeweils ein Polsterelement an gegenüberliegenden Seiten der gestapelten Wafer angeordnet ist. Unter gegenüberliegenden Seiten wird eine Ober- und/oder Unterseite eines Stapels aus Wafern verstanden.

Vorzugsweise hat das Polsterelement im Wesentlichen dieselbe Größe wie ein Wafer, so dass ein vollständiger Schutz entsteht. Alternativ kann ein Polsterelement oder mehrere Polsterelemente an dem peripheren Rand der gestapelten Wafer angeordnet sein.

Insbesondere für den Fall eines quadratischen oder rechteckigen Produktes wird gemäß einer bevorzugten Ausführungsform vorgeschlagen, dass ein sich im Wesentlichen über den gesamten Rand erstreckendes Polsterelement vorgesehen ist, welches mehrere gerade Wandabschnitte aufweist. Die Ecken werden dadurch besonders geschützt und geschont. Vorzugsweise weist das Polsterelement mehrere, vorzugsweise 4 Ausnehmungen auf, die im verpackten Zustand im Wesentlichen gegenüber von den Ecken der Wafer angeordnet sind.

Gemäß einer alternativen Ausführungsform ist vorgesehen, dass das Polsterelement an seiner Außenseite eine höhere Festigkeit oder eine Verstärkungsschicht aufweist.

Bevorzugte Materialien für das Polsterelement sind Schaumstoff, Pappe, Kunststoff, Fils, biologisch abbaubarer Schaum oder geschichtetes Material.

Im Falle einer schrumpfbaren Folie und/oder einer Folieneinschlagverpackung ist es bevorzugt, wenn die schrumpfbare Folie die gestapelten Wafer und das Polsterelement bzw. die Polsterelemente wenigstens teilweise umhüllt und zusammenhält.

Gemäß einer alternativen Ausführungsform ist vorgesehen, dass die Mittel zum Halten der gestapelten Wafer als Schale aus einem im Wesentlichen steifen Material ausgebildet sind. Ein Ein- bzw. Auspacken ist dann besonders einfach möglich, wenn die Schale aus zwei Halbschalen oder mehreren Schalenabschnitten zusammengesetzt ist, insbesondere wenn die Halbschalen seitlich auf die gestapelten Wafer aufsetzbar sind. Alternativ sind die Halbschalen von oben und unten auf die gestapelten Wafer aufsetzbar.

Alternativ wird vorgeschlagen, dass die Mittel zum Halten als Schale mit einem Boden und Seitenwänden ausgebildet ist und die gestapelten Wafer in eine dem Boden gegenüberliegende Öffnung in den Behälter einlegbar sind. Zum besonderen Schutz der Wafer sind Polsterelemente zwischen Boden und Seitenwänden und den gestapelten Wafern angeordnet. Zusätzlich verschließt ein als Polsterelement ausgebildeter Deckel die Schale. Zusätzlich kann eine schrumpfbare Folie die Schale wenigstens teilweise umhüllen.

Gemäß einer alternativen Ausführungsform sind Boden und Deckel mit einer Nut und Feder ausgebildet wird, damit die Behälter besser stapelbar sind. An der Schale angeformte Fixieremente bewirken, dass die gestapelten Wafer fixiert sind.

Die Erfindung löst die Aufgabe ferner mit einer Verpackung mit den Merkmalen des Anspruchs 37, bei der ein Trägerelement zum Tragen eines Wafers vorgesehen ist, welches so ausgebildet ist, dass es zusammen mit mehreren Trägerelementen stapelbar ist.

Vorteilhaft ist hierbei, dass jeder Wafer geschützt auf dem Trägerelement angeordnet ist und mehrere Wafer platzsparend gestapelt werden. Die Stapel aus Trägerelementen mit Wafern werden weiter verpackt, etwa in einem Karton oder auf die nachfolgend beschriebenen Weisen.

Zweckmäßigerweise ist das Trägerelement so dimensioniert ist, dass ein Wafer vollständig auf eine Seite des Trägerelementes auflegbar ist, so dass er gut geschützt ist.

Die Sicherheit der Verpackung und das Handling wird weiter dadurch verbessert, dass das Trägerelement ein oder mehrere Mittel zum Positionieren eines Wafers auf dem Trägerelement aufweist. Besonders bevorzugt ist es wenn das Trägerelement eine Vertiefung aufweist, in welche ein Wafer einlegbar ist. Die Vertiefung ist vorzugsweise so geformt ist, dass sie im Wesentlichen der Kontur eines Wafers entspricht und der Wafer vollständig oder im wesentlichen innerhalb der Vertiefung angeordnet ist. Die Vertiefung kann quaderförmig, quadratisch oder zylindrisch sein.

Die Ecken eines Produktes sind besonders bruchgeschützt, wenn in einer oder allen Ecken einer Vertiefung des Trägerelementes eine sich nach außen erstreckende Ausnehmung ausgebildet ist, die vorzugsweise einen abgerundeten Rand aufweist.

Gemäß einer Weiterbildung ist vorgesehen, dass mehrere Vertiefungen bzw Mittel zum Positionieren. an dem Trägerelement ausgebildet sind, vorzugsweise so, dass mehrere Wafer zueinander auf dem Trägerelement ablegbar sind.

Die Trägerelemente werden dadurch weitergebildet, dass einzelne Trägerelemente von ihrer Oberflächenstruktur so gestaltet sind, dass das Produkt sich sehr einfach von dem Trennelement lösen lässt, insbesondere dadurch, dass Luftströmungen zwischen dem Trennelement und dem Produkt einfach möglich sind, wie zum Beispiel durch Noppen, strukturierte Luftkanäle, Ausschnitte oder Durchgänge im/ auf dem Trennelement. Beispielsweise sind auf einer Seite des Trägerelementes, auf die ein Wafer ablegbar ist, mehrere Erhebungen und/oder Vertiefungen ausgebildet sind.

Das Trägerelement ist zur Erzielung eines minimalen Volumens der gesamten Verpackung so dimensioniert ist, dass dessen Dicke gering ist im Verhältnis zur Breite und/oder Länge. Das Trägerelement kann zur Aufnahme eines Wafers oder mehrerer nebeneinander angeordneter Wafer ausgebildet sein.

Besonders bevorzugt ist eine Variante, bei der ein Informationsträger an dem Trägerelement angeordnet ist, um waferpezifische Informationen z.B. betreffend Herstellungsort- und -zeit bereitstellen zu können. Der Informationsträger ist vorzugsweise im Bereich des Randes des Trägerelementes, vorzugsweise auf einer Seitenfläche benachbart zum Rand des Trägerelementes angeordnet. Er kann einen Barcode, RFID, Datenchip, gedrucktes Label oder ähnliches aufweisen.

Gemäß einer Weiterbildung wird vorgeschlagen, dass im Randbereich des Trägerelementes eine oder mehrere Einbuchtungen und/oder ein oder mehrere Vorsprünge ausgebildet ist/sind, um diese mit einfachen Mitteln zu positionieren oder einfacher manuell oder maschinell entnehmen zu können. Die Einbuchtungen bzw. Vorsprünge sind vorzugsweise an gegenüberliegenden Rändern des Trägerelementes ausgebildet und rechteckig geformt oder gerundet.

Weitere Vorteile ergeben sich, wenn das Trägerelement aus Pappe, Kunststoff, Folie, Tiefziehfolie, Metall oder organisch abbaubaren, strukturfesten Materialien ausgebildet ist.

Die Verpackung wird weiter verstärkt, indem mindestens ein Polsterelement an einer Außenseite gestapelter Trägerelemente und/oder an einer Außenseite oder beiden gegenüberliegenden Außenseiten der gestapelten Trägerelemente angeordnet ist. Es hat etwa dieselbe Größe wie ein Trägerelement und ist an dem peripheren Rand der gestapelten Trägerelemente angeordnet ist. Das Polsterelement kann an seiner Außenseite eine höhere Festigkeit oder eine Verstärkungsschicht aufweisen. Bevorzugte Materialien sind Schaumstoff, Pappe, Kunststoff oder geschichtete Materialien.

Bevorzugt sind Mittel zum Halten der gestapelten Trägerelemente vorgesehen, die etwa als Folieneinschlagverpackung und/oder oder schrumpfbare Folie ausgebildet sind, die die gestapelten Trägerelemente und ggf. das Polsterelement bzw. die Polsterelemente wenigstens teilweise umhüllen.

Alternativ ist das Mittel zum Halten der gestapelten Trägerelemente als Schale aus einem im Wesentlichen steifen Material ausgebildet. Die Schale kann aus zwei Halbschalen oder mehreren Schalenabschnitten zusammengesetzt sein. Die Halbschalen sind seitlich oder von oben und unten auf die gestapelten Trägerelemente aufsetzbar.

Alternativ ist das Mittel zum Halten als Schale mit einem Boden und Seitenwänden ausgebildet, so dass die gestapelten Trägerelemente durch eine dem Boden gegenüberliegende Öffnung in die Schale einlegbar sind.

Die Erfindung ist nachfolgend anhand bevorzugter Ausführungsbeispiele unter Bezugnahme auf die anliegenden Figuren erläutert. Es zeigen:
- Fig. 1: ein erstes Ausführungsbeispiel einer erfindungsgemäßen Verpackung in Schnittdarstellungen a, b, und c;
- Figur 2: ein zweites Ausführungsbeispiel einer erfindungsgemäßen Verpackung als Schnittdarstellung;
- Figur 3: das Ausführungsbeispiel aus Figur 2 in einer Seitenansicht;
- Figur 4: ein weiteres Ausführungsbeispiel einer erfindungsgemäßen Verpackung in einer Explosionsdarstellung;
- Figur 5: das Ausführungsbespiel gemäß Figur 4 als Explosions-Schnittdarstellung;
- Figur 6: ein weiteres Ausführungsführungsbeispiel einer erfindungsgemäßen Verpackung in einer Teilschnittdarstellung;
- Figur 7: das Ausführungsbeispiel gemäß Figur 6 in einer Schnittdarstellung;
- Figur 8: ein weiteres Ausführungsbeispiel einer erfindungsgemäßen Verpackung in einer Seitenansicht;
- Figur 9: das Ausführungsbeispiel aus Figur 8 in einer Schnittdarstellung;
- Figur 10: ein weiteres Ausführungsbespiel einer erfindungsgemäßen Verpackung mit einem Trägerelement;
- Figur 11: das Ausführungsbeispiel gemäß Figur 10 in einer Explosions-Schnittdarstellung;
- Figur 12: ein weiteres Ausführungsbeispiel einer erfindungsgemäßen Verpackung mit einem Trägerelement für mehrere Produkte;
- Figur 13: eine Schnittdarstellung des Ausführungsbeispiels gemäß Figur 12.

Die in den Figuren gezeigten Verpackungen sind zum Verpacken scheibenförmiger, insbesondere dünner, spröder Produkte wie Wafer oder Solarzellen oder dergleichen vorgesehen. In den nachfolgenden Beschreibungen ist hinsichtlich der Produkte in erster Linie von Wafern die Rede, jedoch ist dies beispielhaft zu verstehen und es können beliebige andere Produkte, beispielsweise Solarzellen oder dergleichen verpackt werden. Die Produkte können eine Kreisform aufweisen, quadratisch oder rechteckig oder quaderförmig sein. Alternativ sind auch andere Produktformen denkbar.

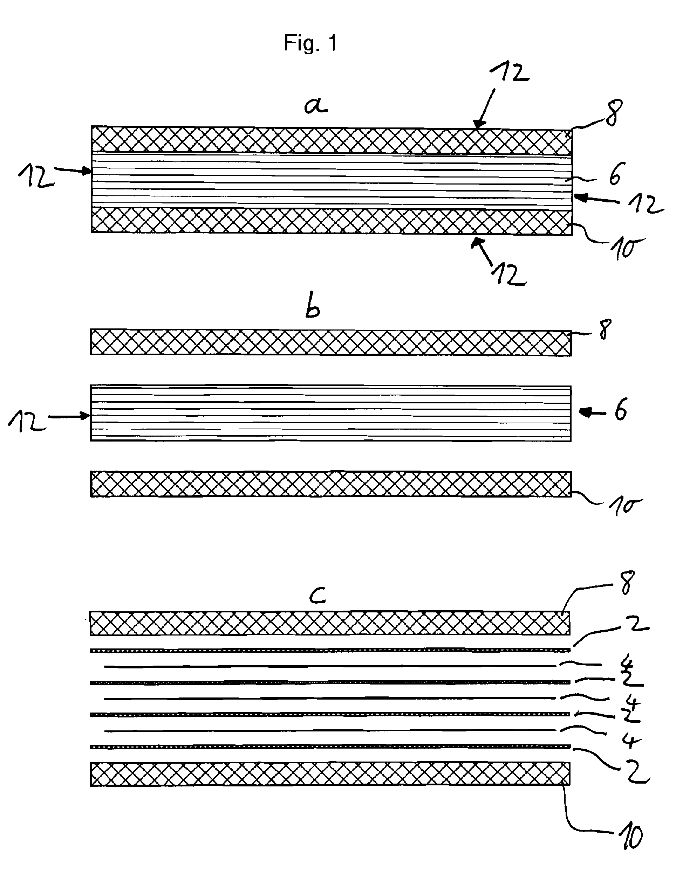

Bei der in den Figuren 1a-c gezeigten Verpackung sind mehrere Wafer oder Solarzellen 2 übereinander gestapelt. Trennelemente 4 sind zwischen den Wafern 2 angeordnet (siehe Figur 1a). Die Wafer 4 nebst Trennelementen 4 bilden einen Stapel bzw. Waferstapel 6 (Figur 1b). Jedes Trennelement 4 stellt eine dünne Zwischenlage dar und ist aus einem verformbaren Material wie beispielsweise Pappe, Papier, Tissuepapier, Folie, Filz, Flies, Kunststoff, Schaum, biologisch abbaubaren Schaum oder geschichtetem Material ausgebildet. Das Trennelement 4 hat im Wesentlichen dieselbe Form wie ein Wafer 2 oder ist etwas kleiner als der Wafer 2. In nicht dargestellter Weise kann ein Trennelement 4 seitlich von den Wafern 2 bzw. dem Stapel 6 abstehen, so dass es manuell ergriffen werden kann. Hierzu kann an dem Trennelement 4 ein Ansatz nach Art einer Lasche angeformt sein oder aber das Trennelement 4 größer als das Produkt 2 dimensioniert sein.

Eine obere Deckplatte 8 und eine untere Deckplatte 10 sind ober- bzw. unterhalb des Stapels 6 angebracht und schützen den Stapel 6 und damit die einzelnen Produkte 2. Sie können aus einem Schaumstoff, Pappe, Kunststoff, Filz, Schaum oder anderem geschichteten Material ausgebildet sein und auch als Polsterelement bezeichnet werden.

Eine Folieneinschlagverpackung, die eine Folie 12 aufweist (siehe Figur 1a) umhüllt den Stapel 6 und in diesem Ausführungsbeispiel auch die Deckplatte 8, 10. Erfindungsgemäß ist es auch möglich, dass der Stapel 6 aus einzelnen Produkten 2, ggf. mit den Trennelementen 4, in eine Folieneinschlagverpackung 12 eingeschlagen ist. Optional könnte ein in eine Folieneinschlagverpackung eingeschlagener Stapel 6 zusammen mit den Deckplatten 8, 10 in eine weitere äußere Folieneinschlagverpackung 12 eingeschlagen sein oder alternativ in eine schrumpfbare Folie (Schrumpffolie). Die Folie 12 der Folieneinschlagverpackung kann eine transparente dünne Folie aus einem Kunststoff oder mit einem Kleber versehenes oder beschichtets Papier sein. In nicht dargestellter Weise kann in der Folie 12 eine Perforation oder ein Aufreißstreifen integriert sein, um die Folie auf einfache Weise öffnen zu können. Durch die Folie 12 ist ein Mittel zum Halten der gestapelten Wafer 2 ausgebildet.

In nicht dargestellter Weise sind einzelne Trennelemente 4 in ihrer Oberflächenstruktur so gestaltet sind, dass das Produkt sich sehr einfach von dem Trennelement 4 lösen lässt, insbesondere dadurch, dass Luftströmung zwischen dem Trennelement 4 und dem Produkt einfach möglich wird, wie zum Beispiel durch Noppen, strukturierte Luftkanäle, Ausschnitte oder Durchgänge im oder auf dem Trennelement 4. Beispielsweise können Noppen oder Vertiefungen an der Ober- und Unterseite der Trennelemente 4 angeordnet sein.

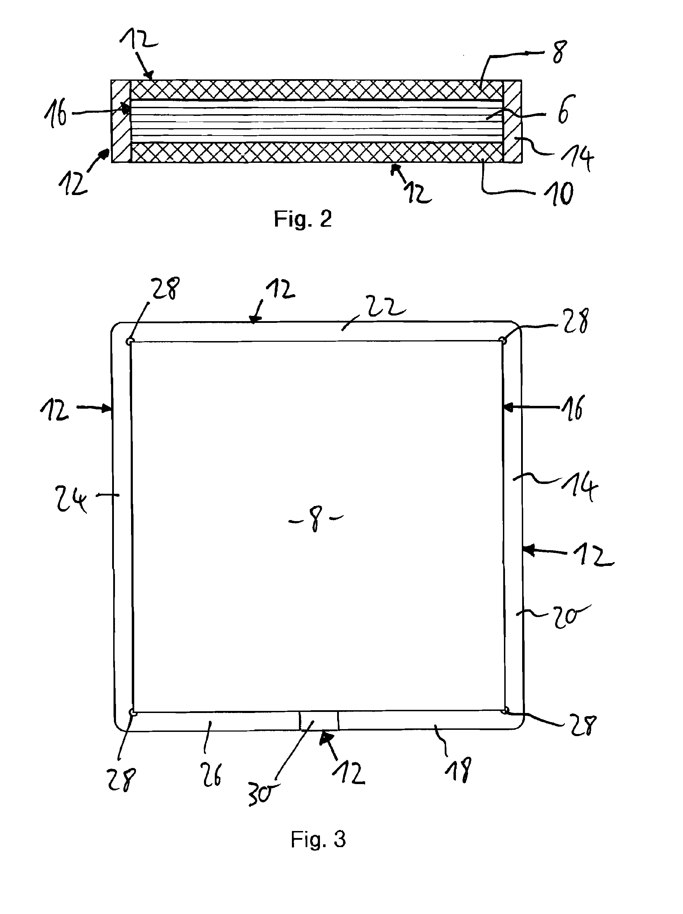

Bei dem in den Figuren 2 und 3 gezeigten alternativen Ausführungsbeispiel ist ein Stapel 6 aus Wafern 2, ggf. zusätzlich mit Trennelementen 4, wie anhand von Figur 1 beschrieben von Deckplatten 8, 10 umgeben. Zusätzlich ist ein Polsterelement 14 an dem peripheren umlaufenden Rand 16 des Stapels 6 aus Wafern 2 angeordnet, um einen zusätzlichen Schutz vor Beschädigungen insbesondere des Randbereiches der Wafer 2 zu erzielen. Die Höhe des Polsterelementes 14 entspricht der Höhe des Stapels 6 zuzüglich der Höhe oder Dicke der Deckplatte 8 und 10, wie Figur 2 zeigt.

Wie aus Figur 3 erkennbar ist, erstreckt sich das Polsterelement 14 im Wesentlichen über den gesamten Rand des Stapels 6 und weist mehrere gerade Wandabschnitte 18, 20, 22, 24, 26 auf, die insgesamt an die etwa rechteckige Außenkontur des Stapels 6 angepasst sind. Die Verpackung ist mittels einer Folie 12 einer Folieneinschlagverpackung fixiert und hält den Stapel 6 und das Polsterelement 14 mit einer Spannung zusammen. Das Polsterelement 14 weist Ausnehmungen 28 auf, die so positioniert sind, dass sie im verpackten Zustand gegenüber von den Ecken der Wafer 2 angeordnet sind, so dass an diesen empfindlichen Ecken kein Kontakt zu dem Polsterelement 14 besteht und somit die Ecken vor Beschädigungen geschützt sind.

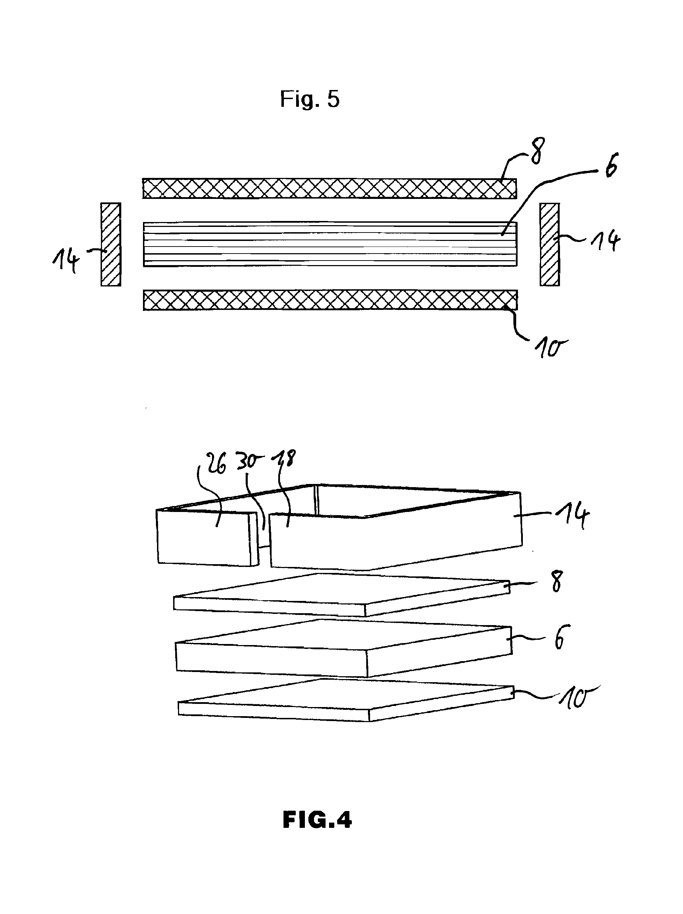

Die Figuren 4 und 5 veranschaulichen das Ausführungsbeispiel gemäß Figuren 2 und 3 in einer explosionsartigen Darstellung, allerdings ohne die Folie 12 der Folieneinschlagverpackung. Figur 4 zeigt, dass die gesamte Länge des Polsterelementes 14, insbesondere der beiden Wandabschnitte 18, 26 so gewählt ist bzw. sind, dass im verpackten Zustand ein Spalt 30 zwischen den Wandabschnitten ausgebildet ist. Dadurch lässt sich das Polsterelement 14 stets stramm um den Stapel 6 herum befestigen und mittels der Folie 12 der Folieneinschlagverpackung fixieren. Das Polsterelement 14 sowie auch die Deckplatten 8, 10 können an ihrer äußeren Oberfläche eine erhöhte Festigkeit aufweisen, beispielsweise indem sie beschichtet sind. Dies erhöht die Festigkeit gegenüber mechanischen Beanspruchungen durch äußere Einwirkungen.

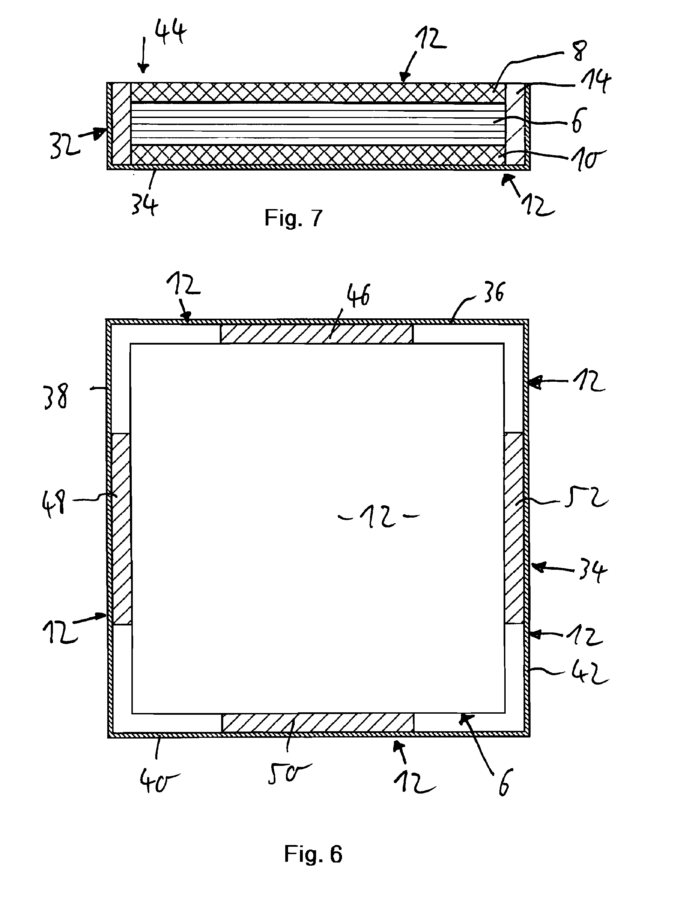

Die in den Figuren 6 und 7 gezeigte Verpackung unterscheidet sich teilweise von den zuvor beschriebenen, wobei nachfolgend die Unterschiede näher erläutert sind und hinsichtlich Gemeinsamkeiten auf die obigen Beschreibungen Bezug genommen wird; gleiche Bauteile sind dabei mit gleichen Bezugszeichen wie oben versehen.

Der Stapel 6 mit Wafern 2 ist von einer oberen und unteren Deckplatte 8, 10 sowie einem Polsterelement 14 umgeben. Eine Schale 32 bildet zusätzlich ein Mittel zum Halten der gestapelten Wafer oder Solarzellen. Die Schale 32 weist einen Boden 34 und mehrere, einen umlaufenden Rand bildende Seitenwände 36, 38, 40, 42 auf (siehe Figur 6). Durch eine obere Öffnung 44 lässt sich der Stapel 6 zusammen mit den Deckplatten 8, 10 und dem Polsterelement 14 in die Schale 34 einlegen. In nicht dargestellter Weise könnte auch ein Stapel 6 aus Wafern 2, der in eine Folieneinschlagverpackung, bestehend aus einer Folie 12, eingeschlagen ist, direkt in die Schale 34 eingelegt werden. In dem gezeigten Ausführungsbeispiel verschließt im Wesentlichen die obere Deckplatte 8 die Öffnung 44 der Schale 32. Eine schrumpfbare Folie 12 oder alternativ eine Folie 12 einer Folieneinschlagverpackung umhüllt die Schale 32 außen, so dass der Stapel 6 aus Wafern 2 sicher in der Verpackung eingepackt ist.

Wie Figur 6 zeigt, besteht das Polsterelement 14 aus einzelnen im Wesentlichen geraden Polsterelement-Abschnitten 46, 48, 50, 52 (Figur 6) die den Stapel 6 seitlich innerhalb der Schale 42 fixieren und schützen.

In nicht dargestellter Weise weist der Boden 34 der Schale 32 mindestens eine Nut auf, in die eine an dem oberen Rand der Seitenwände 36, 38, 40, 42 ausgebildete Feder einführbar ist. Mithilfe der Nut und Feder lassen sich mehrere Schalen 32 positioniert aufeinander stapeln, indem die Federn in die Nut bzw. Nuten eingeführt werden.

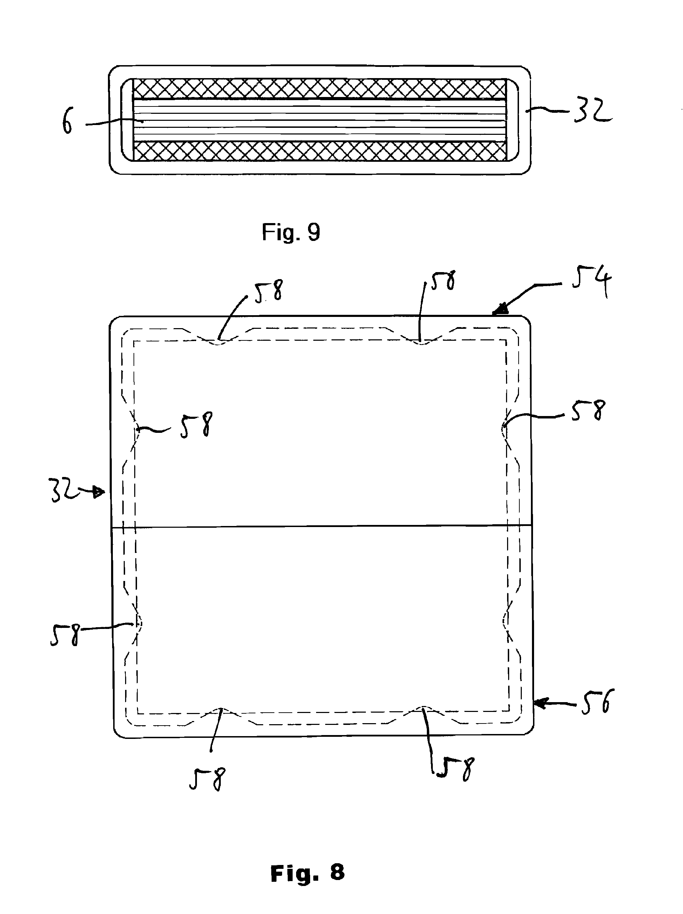

Bei dem alternativen in den Figuren 8 und 9 gezeigten Ausführungsbeispiel ist die Schale 32 aus zwei Halbschalen 54, 56 gebildet. Die beiden Halbschalen 54, 56 lassen sich seitlich auf den Stapel 6 aufschieben. An der inneren Oberfläche der Halbschalen 54, 56 der Schale 32 sind Fixierelemente in Form von mehreren nach innen ragenden Vorsprüngen 58 ausgebildet, die mit dem Stapel 6 an dessen Rand seitlich in Kontakt kommen oder alternativ mit einem Polsterelement 14 oder Abschnitten 46, 48, 50, 52, die ein Polsterelement 14 bilden, in Kontakt kommen, um die gestapelten Wafer 6 zu positionieren innerhalb der Schale 32.

Bei sämtlichen zuvor beschriebenen Ausführungsbeispielen könnte anstelle eines Stapels 6 aus Wafern, die ggf. durch Trennelemente 4 getrennt sind, ein Stapel aus Wafern 2 oder anderen scheibenförmigen Produkten sicher auf die zuvor beschriebene Weise verpackt werden, wobei jedoch die Produkte 2 auf Trägerelementen abgelegt sind, die nachfolgend näher beschrieben sind. Die Trägerelemente nebst Wafern 2 bilden dann einen Stapel 6 und sind prinzipiell wie zuvor beschrieben innerhalb der Verpackung verpackt.

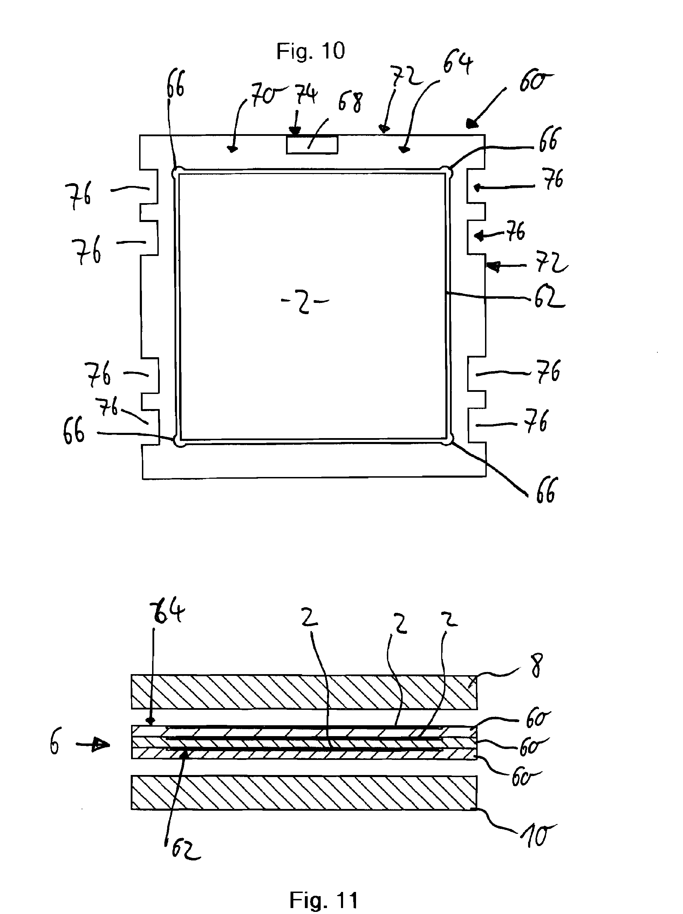

Ein erfindungsgemäßes Trägerelement 60 ist im ersten Ausführungsbeispiel in Figur 10 und 11 gezeigt. Gemäß dem in Figur 11 gezeigten Ausführungsbeispiel sind beispielhaft drei Trägerelemente aufeinander gestapelt, wobei auf jedem Trägerelement 60 ein Produkt wie ein Wafer 2 abgelegt ist. Ein einzelnes Trägerelement 60 stellt bereits eine erfindungsgemäße Verpackung dar. Wafer 2 und Trägerelemente 60 bilden einen Stapel 6, welcher erfindungsgemäß auf die zuvor anhand der Figuren 1 bis 8 beschriebene Weise weiter verpackt werden kann. Ein einzelnes erfindungsgemäßes Trägerelement 60 kann in nicht dargestellter Weise auch auf andere Weise verpackt werden.

Wie aus Figur 10 gut ersichtlich ist, kann ein Wafer 2 (oder anderes Produkt) in einer Vertiefung 62, die an einer Oberseite des Trägers 60 ausgebildet ist und im Wesentlichen der Form des Wafers angepasst ist, abgelegt sein. In dem gezeigten Ausführungsbeispiel ist in die Vertiefung 62 zur Aufnahme des Wafers 2 im Wesentlichen quaderförmig. Es sind jedoch andere Formen, insbesondere eine im Wesentlichen kreisförmige oder zylinderabschnittförmige Vertiefung 62 zur Aufnahme von im Wesentlichen kreisförmigen Produkten 2 denkbar oder auch andere Formen. Die Tiefe der Vertiefung 62 ist vorzugsweise so gewählt, dass das Produkt 2 vollständig innerhalb der Vertiefung 62 angeordnet ist oder die Oberfläche des Produktes 2 im Wesentlichen mit der Oberfläche 64 des Trägerelementes 60 fluchtet. Die Vertiefung 62 bildet gleichzeitig ein Mittel zum Positionieren eines Wafers 2 auf dem Trägerelement 60. Die Vertiefung 62 weist mehrere sich nach außen erstreckende Ausnehmungen 66 auf (Figur 10), die jeweils einen etwas gerundeten Rand aufweisen. Jede Ecke des Wafers kommt so aufgrund der Ausnehmung 66 nicht in Kontakt mit dem Trägerelement 60 und ist somit besonders vor (Spröd-) Bruch geschützt.

Wie die Figuren zeigen, ist jedes Trägerelement 60 so dimensioniert, dass dessen Dicke gering ist im Verhältnis zur Breite und/oder Länge. In nicht dargestellter Weise sind einzelne Trägerelemente von ihrer Oberflächenstruktur so gestaltet sind, dass das Produkt sich sehr einfach von dem Trennelement lösen lässt, insbesondere dadurch, dass Luftströmungen zwischen dem Trennelement und dem Produkt einfach möglich sind, wie zum Beispiel durch Noppen, strukturierte Luftkanäle, Ausschnitte oder Durchgänge im / auf dem Trennelement. So können beispielsweise im Bereich der Vertiefung 62 eine Vielzahl von Noppen und/oder Nuten, die Luftkanäle bilden, an dem Trägerelement 60 ausgebildet sein, die ein "Anhaften" eines Wafers 2 verhindern und ein leichtes Entnehmen eines Wafers 2 von dem Trägerelement 60 ermöglichen. Luftströmungen sind so möglich.

An dem Trägerelement 60 ist ein Informationsträger 68 angebracht, im bevorzugten Ausführungsbeispiel auf einer nach oben weisenden Seitenfläche 70 im Bereich des umlaufenden Randes 72 des Trägerelementes 60. Der Informationsträger 68 kann ein Barcode, RFID, ein Datenchip, ein gedrucktes Label oder dergleichen sein. Ggf. ist der Informationsträger 68 in einer optionalen Vertiefung 74 platziert.

Wie ebenfalls aus Figur 10 ersichtlich ist sind mehrere Einbuchtungen 76 an dem Trägerelement 60 ausgebildet. Im Ausführungsbeispiel sind diese an gegenüberliegenden Rändern positioniert. Mithilfe dieser Einbuchtungen 76, die in nicht dargestellter Weise alternativ auch durch abstehende Vorsprünge ersetzt sein können, lassen sich die Trägerelemente 60 im Bedarfsfall innerhalb eines nicht dargestellten Behältnisses oder in Produktionseinrichtungen positionieren oder führen, beispielsweise indem ein Vorsprung, etwa in Form einer Stange oder dergleichen innerhalb einer Einbuchtung 76 platziert wird.

Das Trägerelement 60 ist beispielsweise aus Pappe, Kunststoff, Folie, Tiefziehfolie, Metall oder organisch abbaubaren, strukturfesten Materialien ausgebildet.

Wie zuvor anhand der Figuren 1 bis 8 beschrieben ist, können die Stapel 6 aus Trägerelementen 60 mit Wafern 2 mithilfe von Polsterelementen, insbesondere Deckplatten 8, 10 oder Polsterelementen 14 an der Ober- und/oder Unterseite und an der peripheren Außenseite geschützt sein und in einer Folieneinschlagverpackung mithilfe einer Folie 12 verpackt sein und/oder zusätzlich in einer Schale, wie zuvor beschrieben, platziert und somit verpackt werden. Insoweit wird vollumfänglich auf die obigen Beschreibungen Bezug genommen.

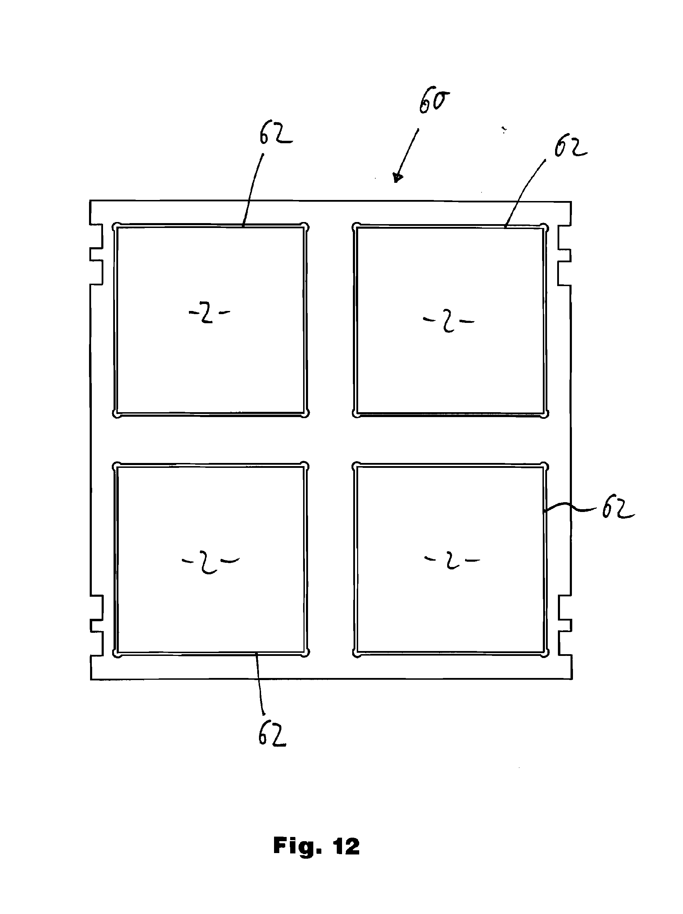

Figur 12 zeigt ein alternatives Ausführungsbeispiel eines Trägerelementes 60, welches eine Reihe von Gemeinsamkeiten mit dem zuvor beschriebenen Ausführungsbeispiel aufweist. Hinsichtlich der Gemeinsamkeiten wird auf die obigen Beschreibungen Bezug genommen und werden gleiche Bezugszeichen verwendet. Nachfolgend sind die abweichenden Merkmale näher erläutert. Das in Figur 12 gezeigte Trägerelement weist mehrere, gezeigt werden vier Vertiefungen 62 zur Aufnahme je eines Produktes 2 auf, die nebeneinander angeordnet sind, so dass vier Wafer 2 aufgenommen werden können. Alternativ sind auch andere Anordnungen mehrerer Vertiefungen 62 denkbar, beispielweise mehrere kreisförmige Vertiefungen 62, die in einem Rechteckmuster oder in einer Reihe oder mehreren Reihen angeordnet sind. Wie zuvor beschrieben, bilden mehrere aufeinander stapelbare Trägerelemente 60 mit mehreren Wafern 2 einen Stapel 6, der mit einer schrumpfbaren Folie oder mit einer Folieneinschlagverpackung 12 verpackt und eingeschlagen werden kann und auf die zuvor beschriebenen Weise in einer Schale ggf. zusammen mit dem Polsterelement verpackt werden kann.

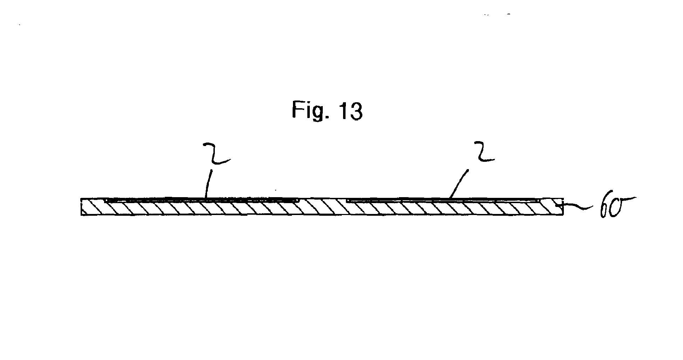

Figur 13 zeigt die jeweils in einer Vertiefung 62 angeordneten Produkte 2 in einer Schnittdarstellung. In einem Stapel können mehrere, beispielsweise 5, 10 oder auch 15 oder mehr Trägerelemente 60 mit also insgesamt einer Vielzahl von Produkten vorhanden sein.

Die Erfindung ist näher anhand der nachstehenden Ausführungsbeispiele beschrieben:
Ausführungsform 1. Verpackung für scheibenförmige, insbesondere dünne, spröde Produkte, **dadurch gekennzeichnet, dass** es sich um bei der Verpackung um eine Folieneinschlagverpackung handelt.
Ausführungsform 2. Verpackung nach Ausführungsform 1, **dadurch gekennzeichnet, dass** es sich bei den Produkten um Wafer oder Solarzellen handelt.
Ausführungsform 3. Verpackung nach Ausführungsform 2, **dadurch gekennzeichnet, dass** die Wafer oder Solarzellen direkt aufeinander gestapelt sind und dass dieser Waferstapel direkt in Folie eingeschlagen ist.
Ausführungsform 4. Verpackung nach einer der vorstehenden Ausführungsformen, **dadurch gekennzeichnet, dass** oben und unten an dem Stapel eine gepolsterte und/oder harte Deckplatte angebracht und der damit entstehende Stapel in Folie eingeschlagen wird.
Ausführungsform 5. Verpackung nach einer der vorstehenden Ausführungsformen 2 bis 4, **dadurch gekennzeichnet, dass** zwischen die Wafer oder Solarzellen des Stapels ein oder mehrere Trennelemente gelegt ist und dass dieser Waferstapel mit Trennelement(en) direkt in Folie eingeschlagen ist.
Ausführungsform 6. Verpackung nach einer der vorstehenden Ausführungsformen 2 bis 4, **dadurch gekennzeichnet, dass** oben und unten an dem Stapel eine gepolsterte und/oder harte Deckplatte angebracht und der damit entstehende Stapel in Folie eingeschlagen ist.
Ausführungsform 7. Verpackung nach einer der vorstehenden Ausführungsformen, **dadurch gekennzeichnet, dass** es sich um eine Kombination von Schrumpffolie und Folieneinschlagverpackung handel kann.
Ausführungsform 8. Verpackung nach einer der vorstehenden Ausführungsformen, **dadurch gekennzeichnet, dass** die Folienverpackung eine definierte Möglichkeit zum Öffnen der Folie über einen Aufreißstreifen oder eine Perforation in der Folie vorsieht.
Ausführungsform 9. Verpackung, insbesondere nach Ausführungsform 1 bis 8, **dadurch gekennzeichnet, dass** mindestens ein Trennelement zwischen benachbarten Wafern oder Solarzellen angeordnet ist.
Ausführungsform 10 Verpackung nach Ausführungsform 1 bis 9,
   **dadurch gekennzeichnet, dass** ein Trennelement zwischen allen benachbarten Wafern oder Solarzellen angeordnet ist.
Ausführungsform 11. Verpackung nach Ausführungsform 9 oder 10,
   **dadurch gekennzeichnet, dass** das Trennelement als dünne Zwischenlage aus einem verformbaren Material, insbesondere Pappe, Papier, Tissuepapier, Folie, Filz, Flies, Kunststoff, Schaum, biologisch abbaubaren Schaum oder geschichtetem Material ausgebildet ist.
Ausführungsform 12. Verpackung nach einer der vorstehenden Ausführungsformen,
   **dadurch gekennzeichnet, dass** das Trennelement im Wesentlichen dieselbe Form wie ein gestapelter Wafer aufweist, so dass gestapelte benachbarte Wafer oder Solarzellen nicht in Kontakt stehen.
Ausführungsform 13. Verpackung nach einer der vorstehenden Ausführungsformen,
   **dadurch gekennzeichnet, dass** das Trennelement eine solche Größe und/oder Form hat, dass benachbarte Wafer oder Solarzellen nur teilweise nicht in direktem Kontakt zueinander stehen.
Ausführungsform 14. Verpackung nach einer der vorstehenden Ausführungsformen,
   **dadurch gekennzeichnet, dass** das Trennelement eine solche Größe aufweist und/oder so zwischen benachbarten Wafern oder Solarzellen angeordnet ist, dass das Trennelement teilweise seitlich von benachbarten Wafern oder Solarzellen absteht.
Ausführungsform 15. Verpackung nach einer der vorstehenden Ausführungsformen,
   **dadurch gekennzeichnet, dass** mehrere Trennelemente im Wesentlichen identisch oder unterschiedlich ausgebildet sind, insbesondere dass die Trennelemente aus verschiedenen Materialien geschichtet sind, um über die Schichtung einen Druck gegen die Verpackungsfolie im Gesamtpaket aufzubauen.
Ausführungsform 16. Verpackung nach einer der vorstehenden Ausführungsformen,
   **dadurch gekennzeichnet, dass** einzelne Trennelemente von ihrer Oberflächenstruktur so gestaltet sind, dass das Produkt sich sehr einfach von dem Trennelement lösen lässt, insbesondere
   dadurch, dass Luftströmung zwischen dem Trennelement und dem Produkt einfach möglich wird, wie zum Beispiel durch Noppen, strukturierte Luftkanäle, Ausschnitte oder Durchgänge im/ auf dem Trennelement.
Ausführungsform 17. Verpackung für scheibenförmige Produkte,
   mit einem Mittel zum Halten mehrerer gestapelter Wafer oder Solarzellen, insbesondere nach einem der vorstehenden Ansprüche,
   **dadurch gekennzeichnet, dass** mindestens ein Polsterelement an einer Außenseite der gestapelten Wafer oder Solarzellen angeordnet ist.
Ausführungsform 18. Verpackung nach Ausführungsform 17,
   **dadurch gekennzeichnet, dass** jeweils ein Polsterelement an gegenüberliegenden Seiten der gestapelten Wafer oder Solarzellen angeordnet ist.
Ausführungsform 19. Verpackung nach Ausführungsform 17 oder 18,
   **dadurch gekennzeichnet, dass** Polsterelement im Wesentlichen dieselbe Größe wie ein Wafer oder eine Solarzellen hat.
Ausführungsform 20. Verpackung nach einer der vorstehenden Ausführungsformen,
   **dadurch gekennzeichnet, dass** ein Polsterelement oder mehrere Polsterelemente an dem peripheren Rand der gestapelten Wafer oder Solarzellen angeordnet ist bzw. sind.
Ausführungsform 21. Verpackung nach Ausführungsform 20,
   **dadurch gekennzeichnet, dass** ein sich im Wesentlichen über den gesamten Rand erstreckendes Polsterelement vorgesehen ist, welches vorzugsweise mehrere gerade Wandabschnitte aufweist.
Ausführungsform 22. Verpackung nach Ausführungsform 21,
   **dadurch gekennzeichnet, dass** das Polsterelement mehrere, vorzugsweise 4 Ausnehmungen aufweist, die im verpackten Zustand im Wesentlichen gegenüber von den Ecken der Wafer oder Solarzellen angeordnet sind.
Ausführungsform 23. Verpackung nach mindestens einer der Ausführungsformen 17 bis 22,
   **dadurch gekennzeichnet, dass** das Polsterelement an seiner Außenseite eine höhere Festigkeit oder eine Verstärkungsschicht aufweist.
Ausführungsform 24. Verpackung nach einer der Ausführungsformen 17 bis 23,
   **dadurch gekennzeichnet, dass** das Polsterelement aus einem Schaumstoff, Pappe, Kunststoff, Fils, biologisch abbaubaren Schaum oder geschichtetem Material ausgebildet ist.
Ausführungsform 25. Verpackung nach mindestens einer der vorstehenden Ausführungsform,
   **dadurch gekennzeichnet, dass** die Mittel zum Halten der gestapelten Wafer oder Solarzellen als schrumpfbare Folie ausgebildet ist
Ausführungsform 26. Verpackung nach Ausführungsform 25,
   **dadurch gekennzeichnet, dass** die schrumpfbare Folie die gestapelten Wafer oder Solarzellen und das Polsterelement bzw. die Polsterelemente wenigstens teilweise umhüllt und zusammenhält.
Ausführungsform 27. Verpackung nach mindestens einer der vorstehenden Ausführungsformen, **dadurch gekennzeichnet, dass** die Mittel zum Halten der gestapelten Wafer oder Solarzellen als Schale aus einem im Wesentlichen steifen Material ausgebildet ist.
Ausführungsform 28. Verpackung nach Ausführungsform 27,
   **dadurch gekennzeichnet, dass** die Schale aus zwei Halbschalen oder mehreren Schalenabschnitten zusammengesetzt ist.
Ausführungsform 29. Verpackung nach Ausführungsform 28,
   **dadurch gekennzeichnet, dass** die Halbschalen seitlich auf die gestapelten Wafer oder Solarzellen aufsetzbar sind.
Ausführungsform 30. Verpackung nach Ausführungsform 29,
   **dadurch gekennzeichnet, dass** die Halbschalen von oben und unten auf die gestapelten Wafer oder Solarzellen aufsetzbar sind.
Ausführungsform 31. Verpackung nach einer der vorstehenden Ausführungsformen,
   **dadurch gekennzeichnet, dass** die Mittel zum Halten als Schale mit einem Boden und Seitenwänden ausgebildet ist und die gestapelten Wafer oder Solarzellen in eine dem Boden gegenüberliegende Öffnung in den Behälter einlegbar sind.
Ausführungsform 32. Verpackung nach Ausführungsform 31,
   **dadurch gekennzeichnet, dass** Polsterelemente zwischen Boden und Seitenwänden und den gestapelten Wafern oder Solarzellen angeordnet sind.
Ausführungsform 33. Verpackung nach Ausführungsform 32,
   **dadurch gekennzeichnet, dass** ein als Polsterelement ausgebildeter Deckel die Schale verschließt.
Ausführungsform 34. Verpackung nach Ausführungsform 33,
   **dadurch gekennzeichnet, dass** eine schrumpfbare Folie die Schale wenigstens teilweise umhüllt.
Ausführungsform 35. Verpackung nach Ausführungsform 34,
   **dadurch gekennzeichnet, dass** Boden und Deckel mit einer Nut und Feder ausgebildet wird, damit die Behälter stapelbar sind.
Ausführungsform 36 . Verpackung nach Ausführungsform 35,
   **dadurch gekennzeichnet, dass** an der Schale angeformte Fixieremente bewirken, dass die gestapelten Wafer oder Solarzellen fixiert sind.
Ausführungsform 37. Verpackung für scheibenförmige Produkte, insbesondere nach einer der vorstehenden Ausführungsformen,
   gekennzeichnet durch ein Trägerelement zum Tragen eines Wafers oder einer Solarzelle, welches so ausgebildet ist, dass es zusammen mit mehreren Trägerelementen stapelbar ist.
Ausführungsform 38. Verpackung nach Ausführungsform 37,
   **dadurch gekennzeichnet, dass** das Trägerelement so dimensioniert ist, dass ein Wafer oder eine Solarzelle vollständig auf eine Seite des Trägerelementes auflegbar ist.
Ausführungsform 39. Verpackung nach Ausführungsform 37 oder 38,
   **dadurch gekennzeichnet, dass** das Trägerelement Mittel zum Positionieren eines Wafer oder eine Solarzelle auf dem Trägerelement aufweist.
Ausführungsform 40. Verpackung nach einer der vorstehenden Ausführungsformen 37 bis 39,
   **dadurch gekennzeichnet, dass** das Trägerelement eine Vertiefung aufweist, in welche ein Wafer oder eine Solarzelle einlegbar ist.
Ausführungsform 41. Verpackung nach Ausführungsform 40,
   **dadurch gekennzeichnet, dass** die Vertiefung so geformt ist, dass sie im Wesentlichen der Kontur eines Wafers oder einer Solarzelle entspricht und der Wafer oder die Solarzelle vollständig oder im Wesentlichen innerhalb der Vertiefung angeordnet ist.
Ausführungsform 42. Verpackung nach Ausführungsform 41,
   **dadurch gekennzeichnet, dass** die Vertiefung im Wesentlichen quaderförmig, quadratisch oder zylindrisch ist.
Ausführungsform 43. Verpackung nach einer der Ausführungsformen 40 bis 42,
   **dadurch gekennzeichnet, dass** in einer oder allen Ecken einer Vertiefung eine sich nach außen erstreckende Ausnehmung ausgebildet ist.
Ausführungsform 44. Verpackung nach Ausführungsform 43,
   **dadurch gekennzeichnet, dass** die Ausnehmung im Wesentlichen einen abgerundeten Rand aufweist.
Ausführungsform 45. Verpackung nach einer der vorstehenden Ausführungsformen,
   **dadurch gekennzeichnet, dass** mehrere Mittel zum Positionieren eines Wafer oder einer Solarzelle und/oder mehrere Vertiefungen an dem Trägerelement vorgesehen sind.
Ausführungsform 46. Verpackung nach Ausführungsform 45,
   **dadurch gekennzeichnet, dass** zwei, drei oder mehrere Mittel zum Positionieren bzw. Vertiefungen an dem Trägerelement ausgebildet sind, vorzugsweise so, dass zwei, drei oder mehrere Wafer oder Solarzellen mehr oder weniger gleichmäßig beabstandet zueinander auf dem Trägerelement ablegbar sind.
Ausführungsform 47 Verpackung nach einer der vorstehenden Ausführungsformen,
   **dadurch gekennzeichnet, dass** einzelne Trägerelemente von ihrer Oberflächenstruktur so gestaltet sind, dass das Produkt sich sehr einfach von dem Trennelement lösen lässt, insbesondere dadurch, dass Luftströmungen zwischen dem Trennelement und dem Produkt einfach möglich sind, wie zum Beispiel durch Noppen, strukturierte Luftkanäle, Ausschnitte oder Durchgänge im/ auf dem Trennelement.
Ausführungsform 48. Verpackung nach Ausführungsform 47,
   **dadurch gekennzeichnet, dass** auf einer Seite des Trägerelementes, auf die ein Wafer oder eine Solarzelle ablegbar ist, mehrere Erhebungen ausgebildet sind, auf die ein Wafer oder eine Solarzelle auflegbar ist.
Ausführungsform 49. Verpackung nach einer der vorstehenden Ausführungsformen 47,
   **dadurch gekennzeichnet, dass** auf einer Seite des Trägerelementes, auf die ein Wafer oder eine Solarzelle ablegbar ist, mehrere Vertiefungen ausgebildet sind.
Ausführungsform 50. Verpackung nach mindestens einer der vorstehenden Ausführungsformen 37 bis 49,
   **dadurch gekennzeichnet, dass** das Trägerelement so dimensioniert ist, dass dessen Dicke gering ist im Verhältnis zur Breite und/oder Länge.
Ausführungsform 51. Verpackung nach einer der Ausführungsformen 37 bis 50,
   **dadurch gekennzeichnet, dass** das Trägerelement zur Aufnahme eines Wafer oder einer Solarzelle oder mehrerer nebeneinander angeordneter Wafer oder Solarzellen ausgebildet ist, und mehrere Trägerelemente so aufeinander stapelbar sind, dass die gestapelten Wafer oder Solarzellen sich nicht berühren.
Ausführungsform 52. Verpackung nach einer der vorstehenden Ausführungsformen 37 bis 51, **dadurch gekennzeichnet, dass** ein Informationsträger an dem Trägerelement angeordnet ist.
Ausführungsform 53. Verpackung nach Ausführungsform 52,
   **dadurch gekennzeichnet, dass** der Informationsträger im Bereich des Randes des Trägerelementes, vorzugsweise auf einer Seitenfläche benachbart zum Rand des Trägerelementes angeordnet ist.
Ausführungsform 54. Verpackung nach einer der Ausführungsformen 52 und 53,
   **dadurch gekennzeichnet, dass** der Informationsträger einen Barcode, RFID, Datenchip, gedrucktes Label oder ähnliches aufweist.
Ausführungsform 55. Verpackung nach einer der Ausführungsformen 37 bis 54,
   **dadurch gekennzeichnet, dass** im Randbereich des Trägerelementes eine oder mehrere Einbuchtungen und/oder ein oder mehrere Vorsprünge ausgebildet ist/sind.
Ausführungsform 56. Verpackung nach Ausführungsform 55,
   **dadurch gekennzeichnet, dass** die Einbuchtungen bzw. Vorsprünge an gegenüberliegenden Rändern des Trägerelementes ausgebildet sind.
Ausführungsform 57. Verpackung nach Ausführungsform 55,
   **dadurch gekennzeichnet, dass** eine Einbuchtung im Wesentlichen rechteckig geformt oder gerundet ist.
Ausführungsform 58. Verpackung nach einer der Ausführungsformen 37 bis 57,
   **dadurch gekennzeichnet, dass** das Trägerelement aus Pappe, Kunststoff, Folie, Tiefziehfolie, Metall oder organisch abbaubaren, strukturfesten Materialien ausgebildet ist.
Ausführungsform 59. Verpackung nach einer der Ausführungsformen 37 bis 58,
   **dadurch gekennzeichnet, dass** mindestens ein Polsterelement an einer Außenseite gestapelter Trägerelemente angeordnet ist.
Ausführungsform 60. Verpackung nach Ausführungsform 59,
   **dadurch gekennzeichnet, dass** ein Polsterelement an einer Außenseite oder beiden gegenüberliegenden Außenseiten der gestapelten Trägerelemente angeordnet ist.
Ausführungsform 61. Verpackung nach Ausführungsform 60,
   **dadurch gekennzeichnet, dass** ein Polsterelement im Wesentlichen dieselbe Größe wie ein Trägerelement hat.
Ausführungsform 62. Verpackung nach einer der vorstehenden Ausführungsformen 59 ,
   **dadurch gekennzeichnet, dass** ein Polsterelement oder mehrere Polsterelemente an dem peripheren Rand der gestapelten Trägerelemente angeordnet ist bzw. sind.
Ausführungsform 63. Verpackung nach Ausführungsform 62,
   **dadurch gekennzeichnet, dass** ein sich im Wesentlichen über den gesamten Rand erstreckendes Polsterelement vorgesehen ist.
Ausführungsform 64. Verpackung nach Ausführungsform 59 bis 63,
   **dadurch gekennzeichnet, dass** das Polsterelement an seiner Außenseite eine höhere Festigkeit oder eine Verstärkungsschicht aufweist.
Ausführungsform 65. Verpackung nach einer der Ausführungsformen 59 bis 64,
   **dadurch gekennzeichnet, dass** das Polsterelement aus einem Schaumstoff, Pappe, Kunststoff oder geschichteten Materialien ausgebildet ist.
Ausführungsform 66. Verpackung nach mindestens einer der vorstehenden Ausführungsformen 37 bis 65,
   gekennzeichnet durch Mittel zum Halten der gestapelten Trägerelemente.
Ausführungsform 67. Verpackung nach Ausführungsform 66,
   **dadurch gekennzeichnet, dass** die Mittel als schrumpfbare Folie ausgebildet sind, die die gestapelten Trägerelemente und ggf. das Polsterelement bzw. die Polsterelemente wenigstens teilweise umhüllt.
Ausführungsform 68. Verpackung nach Ausführungsform 66,
   **dadurch gekennzeichnet, dass** das Mittel zum Halten der gestapelten Trägerelemente als Schale aus einem im Wesentlichen steifen Material ausgebildet ist.
Ausführungsform 69. Verpackung nach Ausführungsform 68,
   **dadurch gekennzeichnet, dass** die Schale aus zwei Halbschalen oder mehreren Schalenabschnitten zusammengesetzt ist.
Ausführungsform 70. Verpackung nach Ausführungsform 69,
   **dadurch gekennzeichnet, dass** die Halbschalen seitlich auf die gestapelten Trägerelemente aufsetzbar sind.
Ausführungsform 71. Verpackung nach Ausführungsform 70,
   **dadurch gekennzeichnet, dass** die Halbschalen von oben und unten auf die gestapelten Trägerelemente aufsetzbar sind.
Ausführungsform 72. Verpackung nach einer der vorstehenden Ausführungsformen,
   **dadurch gekennzeichnet, dass** das Mittel zum Halten als Schale mit einem Boden und Seitenwänden ausgebildet ist und die gestapelten Trägerelemente in eine dem Boden gegenüberliegende Öffnung in die Schale einlegbar sind.

## Patentansprüche

1. Verpackung für scheibenförmige, insbesondere dünne, spröde Produkte, **dadurch gekennzeichnet, dass** es sich um bei der Verpackung um eine Folieneinschlagverpackung handelt.

2. Verpackung nach Anspruch 1, **dadurch gekennzeichnet, dass** es sich bei den Produkten um Wafer oder Solarzellen handelt.

3. Verpackung nach Anspruch 2, **dadurch gekennzeichnet, dass** die Wafer oder Solarzellen direkt aufeinander gestapelt sind und dass dieser Waferstapel direkt in Folie eingeschlagen ist.

4. Verpackung nach einem der vorstehenden Ansprüche, **dadurch gekennzeichnet, dass** oben und unten an dem Stapel eine gepolsterte und/oder harte Deckplatte angebracht und der damit entstehende Stapel in Folie eingeschlagen wird.

5. Verpackung nach einem der vorstehenden Ansprüche 2 bis 4, **dadurch gekennzeichnet, dass** zwischen die Wafer oder Solarzellen des Stapels ein oder mehrere Trennelemente gelegt ist und dass dieser Waferstapel mit Trennelement(en) direkt in Folie eingeschlagen ist.

6. Verpackung nach einem der vorstehenden Ansprüchen, **dadurch gekennzeichnet, dass** es sich um eine Kombination von Schrumpffolie und Folieneinschlagverpackung handel kann.

7. Verpackung, insbesondere nach Anspruch 1 bis 6, **dadurch gekennzeichnet, dass** mindestens ein Trennelement zwischen benachbarten Wafern oder Solarzellen angeordnet ist und dass das Trennelement als dünne Zwischenlage aus einem verformbaren Material, insbesondere Pappe, Papier, Tissuepapier, Folie, Filz, Flies, Kunststoff, Schaum, biologisch abbaubaren Schaum oder geschichtetem Material ausgebildet ist.

8. Verpackung nach einem der vorstehenden Ansprüche,
**dadurch gekennzeichnet, dass** das Trennelement eine solche Größe aufweist und/oder so zwischen benachbarten Wafern oder Solarzellen angeordnet ist, dass das Trennelement teilweise seitlich von benachbarten Wafern oder Solarzellen absteht und dass diese mehrere Trennelemente im Wesentlichen identisch oder unterschiedlich ausgebildet sind, insbesondere dass die Trennelemente aus verschiedenen Materialien geschichtet sind, um über die Schichtung einen Druck gegen die Verpackungsfolie im Gesamtpaket aufzubauen.

9. Verpackung nach einem der vorstehenden Ansprüche,
**dadurch gekennzeichnet, dass** einzelne Trennelemente von ihrer Oberflächenstruktur so gestaltet sind, dass das Produkt sich sehr einfach von dem Trennelement lösen lässt, insbesondere **dadurch**, dass Luftströmung zwischen dem Trennelement und dem Produkt einfach möglich wird, wie zum Beispiel durch Noppen, strukturierte Luftkanäle, Ausschnitte oder Durchgänge im/ auf dem Trennelement.

10. Verpackung für scheibenförmige Produkte,
mit einem Mittel zum Halten mehrerer gestapelter Wafer oder Solarzellen, insbesondere nach einem der vorstehenden Ansprüche,
**dadurch gekennzeichnet, dass** mindestens ein Polsterelement an einer Außenseite der gestapelten Wafer oder Solarzellen angeordnet ist, insbesondere derart, dass
i) jeweils ein Polsterelement an gegenüberliegenden Seiten der gestapelten Wafer oder Solarzellen angeordnet ist; und/oder
ii) ein Polsterelement oder mehrere Polsterelemente an dem peripheren Rand der gestapelten Wafer oder Solarzellen angeordnet ist bzw. sind; und/oder
iii) ein sich im Wesentlichen über den gesamten Rand erstreckendes Polsterelement vorgesehen ist, welches vorzugsweise mehrere gerade Wandabschnitte aufweist; und/oder
iv) das Polsterelement mehrere, vorzugsweise 4 Ausnehmungen aufweist, die im verpackten Zustand im Wesentlichen gegenüber von den Ecken der Wafer oder Solarzellen angeordnet sind; und/oder
v) das Polsterelement an seiner Außenseite eine höhere Festigkeit oder eine Verstärkungsschicht aufweist.

11. Verpackung nach mindestens einem der vorstehenden Ansprüche,
**dadurch gekennzeichnet, dass** die Mittel zum Halten der gestapelten Wafer oder Solarzellen als Schale aus einem im Wesentlichen steifen Material ausgebildet ist, insbesondere derart, dass die Schale aus zwei Halbschalen oder mehreren Schalenabschnitten zusammengesetzt ist oder dass die Halbschalen seitlich auf die gestapelten Wafer oder Solarzellen aufsetzbar sind oder dass die Halbschalen von oben und unten auf die gestapelten Wafer oder Solarzellen aufsetzbar sind oder dass die Mittel zum Halten als Schale mit einem Boden und Seitenwänden ausgebildet ist und die gestapelten Wafer oder Solarzellen in eine dem Boden gegenüberliegende Öffnung in den Behälter einlegbar sind

12. Verpackung nach mindestens einem der vorstehenden Ansprüche,
**dadurch gekennzeichnet, dass** die Mittel zum Halten als Schale mit einem Boden und Seitenwänden ausgebildet ist und die gestapelten Wafer oder Solarzellen in eine dem Boden gegenüberliegende Öffnung in den Behälter einlegbar sind,und dass Polsterelemente zwischen Boden und Seitenwänden und den gestapelten Wafern oder Solarzellen angeordnet sind oder dass ein als Polsterelement ausgebildeter Deckel die Schale verschließt.

13. Verpackung nach Anspruch 12,
**dadurch gekennzeichnet, dass** eine schrumpfbare Folie, ein Karton oder ähnliches die Schale wenigstens teilweise umhüllt.

14. Verpackung für scheibenförmige Produkte, insbesondere nach einem der vorstehenden Ansprüche,
**gekennzeichnet durch** ein Trägerelement zum Tragen eines Wafers oder einer Solarzelle, welches so ausgebildet ist, dass es zusammen mit mehreren Trägerelementen stapelbar ist und dass das Trägerelement so dimensioniert ist, dass ein Wafer oder eine Solarzelle vollständig auf eine Seite des Trägerelementes auflegbar ist , wobei insbesondere
i) das Trägerelement Mittel zum Positionieren eines Wafer oder eine Solarzelle auf dem Trägerelement aufweist; und/oder
ii) das Trägerelement eine Vertiefung aufweist, in welches ein Wafer oder eine Solarzelle einlegbar ist; und/oder
iii) die Vertiefung so geformt ist, dass sie im Wesentlichen der Kontur eines Wafers oder einer Solarzelle entspricht und der Wafer oder eine Solarzelle vollständig oder im Wesentlichen innerhalb der Vertiefung angeordnet ist; und/oder
iv) die Vertiefung im Wesentlichen quaderförmig, quadratisch oder zylindrisch ist.

15. Verpackung nach einem der vorstehenden Ansprüche,
**dadurch gekennzeichnet, dass** ein Informationsträger an dem Trägerelement angeordnet ist, wie zum Beispiel im Bereich des Randes des Trägerelementes, vorzugsweise auf einer Seitenfläche benachbart zum Rand des Trägerelementes und dass der Informationsträger einen Barcode, RFID, Datenchip, gedrucktes Label oder ähnliches aufweist.
